# EUROPÄISCHE PATENTSCHRIFT

(11) **EP 3 304 021 B1**
(45) Veröffentlichungstag und Bekanntmachung des Hinweises auf die Patenterteilung: **23.10.2019**
(21) Anmeldenummer: 16717861.5
(22) Anmeldetag: 07.04.2016
(51) Int. Cl.: G01L 13/02, G01L 19/14

(54) **VORRICHTUNG ZUR ERFASSUNG EINES DRUCKS EINES FLUIDEN MEDIUMS UND VERFAHREN ZUR HERSTELLUNG DER VORRICHTUNG**
APPARATUS FOR SENSING A PRESSURE OF A FLUID MEDIUM, AND METHOD FOR MANUFACTURING SAID APPARATUS
DISPOSITIF SERVANT À DÉTECTER UNE PRESSION D'UN MILIEU FLUIDE ET PROCÉDÉ SERVANT À FABRIQUER LE DISPOSITIF

(30) Priorität: 28.05.2015 DE 102015209830; 08.02.2016 DE 102016201847
(43) Veröffentlichungstag der Anmeldung: 11.04.2018
(73) Patentinhaber: Robert Bosch GmbH, 70442 Stuttgart (DE)
(72) Erfinder: HABIBI, Masoud, 71701 Schwieberdingen (DE); REINHARD, Markus, 70806 Kornwestheim (DE); KUHNT, Winfried, 70192 Stuttgart (DE)
(86) Internationale Anmeldenummer: PCT/EP2016/057585
(87) Internationale Veröffentlichungsnummer: WO 2016/188662

(56) Entgegenhaltungen:
- EP-A2- 1 505 380
- DE-A1-102007 016 475
- DE-A1-102008 005 153
- DE-A1-102011 005 933
- US-A- 5 747 694
- US-A1- 2011 048 137

## Beschreibung

### Stand der Technik

Die Erfindung betrifft eine Vorrichtung zur Erfassung eines Drucks eines fluiden Mediums sowie ein Verfahren zur Herstellung der Vorrichtung. Derartige Vorrichtungen werden beispielsweise in der Automobiltechnik eingesetzt, beispielsweise in Partikelfiltern, insbesondere in Dieselpartikelfiltern, bzw. für Partikelfilter oder in Motorsteuerungssystemen mit Partikelfilter sowie in einer Niederdruckabgasrückführung. Die Erfindung ist grundsätzlich auch in anderen Einsatzbereichen denkbar.

Aus dem Stand der Technik sind zahlreiche Vorrichtungen zur Erfassung eines Drucks eines fluiden Mediums bekannt. Aus DE 10 2008 005153 A1 ist ein Druckmessmodul zur Erfassung eines Absolutdrucks oder eines Relativdrucks bekannt. Das Druckmessmodul umfasst ein bevorzugt als Premold gefertigtes Gehäuse, in dem ein Druckmesschip aufgenommen ist. Dieser ist entweder mit einem Stanzgitter oder mit mindestens einer Leiterbahn elektrisch kontaktiert, wobei mindestens ein elektronisches Bauelement vorgesehen ist, welches mit einem seitlich aus dem bevorzugt als Premold gefertigten Gehäuse austretenden Abschnitt des Stanzgitters oder der mindestens einen Leiterbahn verbunden ist und durch eine Unterteilung eines Deckels abgedeckt ist.

In EP 1 521 952 B1 wird eine Vorrichtung zur Druckmessung vorgeschlagen, welche ein Gehäuse aufweist, in dem ein mit einem Sensorelement und mit elektrischen Anschlusselementen versehener Träger angeordnet ist. Das Druckkanal eines erstes Druckanschlusses verbundenen ersten Gehäuseraum und einen gegenüber dem ersten Gehäuseraum abgedichteten, wenigstens die elektrischen Anschlusselemente umgebenden zweiten Gehäuseraum auf. Das Gehäuse weist einen gegenüber dem ersten Gehäuseraum und dem zweiten Gehäuseraum abgedichteten dritten Gehäuseraum auf, der mit einem zweiten Druckkanal eines zweiten Druckanschlusses verbunden ist.

In DE 10 2011 085652 A1 wird eine Vorrichtung zur Erfassung eines Drucks eines fluiden Mediums vorgeschlagen. Die Vorrichtung weist mindestens ein Gehäuse mit mindestens einem Druckraum auf. In dem Druckraum ist mindestens ein Drucksensorelement aufgenommen. Die Vorrichtung weist weiterhin zwischen dem Gehäuse und dem Drucksensorelement mindestens ein Ausgleichselement zum Ausgleich thermomechanischer Spannungen auf. Das Drucksensorelement ist zumindest teilweise mit dem Ausgleichselement verbunden. Das Ausgleichselement weist mindestens eine erste Öffnung auf. Das Drucksensorelement ist über die erste Öffnung mit einem ersten Druck beaufschlagbar. Das Ausgleichselement weist weiterhin mindestens eine zweite Öffnung auf. Über die zweite Öffnung sind der Druckraum und das Drucksensorelement mit mindestens einem zweiten Druck beaufschlagbar.

Bekannte Vorrichtungen zur Erfassung eines Druckes eines fluiden Mediums weisen jedoch eine Mehrzahl an technischen Herausforderungen auf. Üblicherweise umfassen die Vorrichtungen einen Schaltungsträger, welcher ein Keramiksubstrat aufweist. In solches Design kann grundsätzlich zu einen hohen Flächenbedarf führen. Dies kann insbesondere mit hohen Herstellkosten verbunden sein.

Aus den Dokumenten US 5 747 694 A; DE 10 2008 005 153 A1; EP 1 505 380 A2; US 2011/048137 A1, DE 10 2007 016 475 A1 und DE 10 2011 005 933 A1 sind verschiedene Vorrichtungen zur Druckerfassung bekannt.

### Offenbarung der Erfindung

Es werden daher eine Vorrichtung zur Erfassung eines Drucks eines fluiden Mediums und ein Verfahren zur Herstellung der Vorrichtung vorgeschlagen, welche die oben genannten Probleme bekannter Vorrichtungen und Verfahren zumindest weitgehend vermeiden.

Der Begriff "Druck" bezeichnet insbesondere einen Partialdruck und/oder einen Absolutdruck und/oder einen Differenzdruck und/oder ein Druckprofil und/oder eine Druckentwicklung, beispielsweise über die Zeit. Beispielsweise kann es sich bei dem Druck auch um mehrere Drücke handeln, beispielsweise um eine Differenz mehrerer Drücke. Die Vorrichtung kann also insbesondere eine Differenzdruckmessvorrichtung sein, also eine Vorrichtung, welche eingerichtet ist, um eine Differenz zwischen einem ersten Druck p₁, beispielsweise in einem ersten Druckraum, und einem zweiten Druck p₂, beispielsweise in einem zweiten Druckraum, zu erfassen. Beispielsweise kann es sich bei einem dieser Druckräume um einen Referenzdruckraum handeln, beispielsweise einem Raum mit Atmosphärendruck. Auch andere Ausgestaltungen sind jedoch möglich.

Unter einem "fluiden Medium" im Sinne der vorliegenden Erfindung ist grundsätzlich ein beliebiger Stoff im fluiden, insbesondere gasförmigen, Zustand zu verstehen. Beispielsweise kann es sich um einen Stoff handeln, welcher einer beliebig langsamen Scherung keinen Widerstand entgegensetzt. Im Allgemeinen kann der fluide Zustand temperatur- und/oder druckabhängig sein. Das fluide Medium kann als Reinstoff oder als Stoffgemisch vorliegen.

Die Vorrichtung zur Erfassung eines Drucks eines fluiden Mediums umfasst mindestens ein Gehäuse mit mindestens zwei Druckzuführungen und mindestens ein Sensormodul. Das Sensormodul ist in dem Gehäuse aufgenommen. Das Sensormodul umfasst mindestens ein Trägerelement, mindestens ein Drucksensorelement zur Erfassung des Drucks und mindestens eine Steuer- und Auswerteeinheit. Das Trägerelement weist mindestens ein Substrat und mindestens eine Moldmasse auf. Weiterhin weist das Trägerelement mindestens eine Durchlassöffnung auf, welche das Trägerelement vollständig durchdringt. Das Drucksensorelement umfasst mindestens eine Membran. Das Drucksensorelement deckt die Durchlassöffnung ab. Die Steuer- und Auswerteeinheit ist zumindest teilweise von der Moldmasse umschlossen.

Der Begriff "Gehäuse" bezieht sich im Sinne der vorliegenden Erfindung grundsätzlich auf ein beliebig geformtes Element, welches eingerichtet ist, um Bauteile der Vorrichtung ganz oder teilweise zu umschließen und um diese Bauteile weiterhin von externen Einflüssen wie mechanischer Belastung oder Feuchtigkeit zu schützen. Das Gehäuse kann mindestens ein erstes Gehäuseteil, insbesondere eine Gehäusebasis, und mindestens ein zweites Gehäuseteil, insbesondere einen Gehäusedeckel, umfassen. Das erste Gehäuseteil und das zweite Gehäuseteil können stoffschlüssig miteinander verbunden sein.

Die Bezeichnungen "erstes" und "zweites" Gehäuseteil sind als reine Bezeichnungen anzusehen, ohne eine Rangfolge anzugeben und beispielsweise ohne die Möglichkeit auszuschließen, dass mehrere Arten von ersten Gehäuseteilen und mehrere Arten von zweiten Gehäuseteilen oder jeweils genau eine Art vorgesehen sein kann. Weiterhin können zusätzliche Gehäuseteile, beispielsweise dritte Gehäuseteile, vorhanden sein.

Die Vorrichtung kann weiterhin mindestens ein Abdichtungsmaterial umfassen. Das Abdichtungsmaterial kann eingerichtet sein, um das erste Gehäuseteil und das zweite Gehäuseteil miteinander zu verbinden. Das Abdichtungsmaterial kann weiterhin eingerichtet sein, um das Sensormodul mit dem Gehäuse zu verbinden. Das Abdichtungsmaterial kann mindestens ein Material umfassen, welches ausgewählt ist aus der Gruppe bestehend aus: einem Klebstoff, einer Klebefolie, einer Presspassung mit einem Elastomer.

Der Begriff "Klebstoff" bezeichnet grundsätzlich einen Prozesswerkstoff, welcher insbesondere eingerichtet ist, um Bauteile miteinander stoffschlüssig und vorzugsweise irreversibel miteinander zu verbinden. Der Klebstoff kann vorzugsweise eingerichtet sein, um in einem flüssigen Zustand oder viskosen Zustand auf die entsprechenden Bauteile aufgebracht zu werden und anschließend durch einen physikalisch-abbindenden Vorgang und/oder durch einen chemisch härtenden Vorgang in einen festen Zustand übergeht. Der Begriff "Klebefolie" bezeichnet grundsätzlich eine Folie, welche einen Klebstoff umfasst. Beispielsweise kann die Folie aus einem Kunststoffmaterial hergestellt sein.

Das Gehäuse kann mindestens eine Aufnahme zum Aufnehmen des Sensormoduls umfassen. Insbesondere kann es sich bei der Aufnahme um eine Vertiefung handeln. Das Sensormodul kann mittels des Abdichtungsmaterials in der Aufnahme befestigt sein. Das Gehäuse kann mindestens einen Druckraum und mindestens einen Schaltungsraum umschließen. Der Druckraum kann gegenüber dem Schaltungsraum abgedichtet sein. In dem Schaltungsraum kann mindestens ein elektronisches Bauteil aufgenommen sein. Das Sensormodul kann teilweise in dem Druckraum und teilweise in dem Schaltungsraum angeordnet sein und gegen das Gehäuse abgedichtet sein.

Bei dem "Druckraum" kann es sich prinzipiell um einen beliebigen Raum handeln, welcher bevorzugt keine elektronischen Bauteile umfasst und zumindest teilweise abgeschlossen ist, insbesondere gegenüber einer Umwelt. Der Druckraum kann insbesondere ein Raum sein, in welchem mindestens ein Druck des fluiden Mediums herrscht, welcher von der Vorrichtung erfasst wird.

Der Begriff "Schaltungsraum" bezeichnet prinzipiell einen beliebigen Raum, welcher zumindest teilweise abgeschlossen ist, insbesondere gegenüber der Umwelt, und in welchem mindestens ein elektronisches Bauteil aufgenommen sein kann. Insbesondere können die elektronischen Bauteile des Schaltungsraums ausgestaltet sein, um das Drucksensorelement mit mindestens einem elektrischen Strom und/oder mindestens einer elektrischen Spannung zu beaufschlagen.

Das Gehäuse umfasst mindestens zwei Druckzuführungen. Erfindungsgemäß handelt es sich um eine erste Druckzuführung und um eine zweite Druckzuführung. Die Bezeichnungen "erste" und "zweite" Druckzuführung sind wiederum als reine Bezeichnungen anzusehen, ohne eine Rangfolge anzugeben und beispielsweise ohne die Möglichkeit auszuschließen, dass mehrere Arten von ersten Druckzuführungen und mehrere Arten von zweiten Druckzuführungen oder jeweils genau eine Art vorgesehen sein kann. Weiterhin können zusätzliche Druckzuführungen, beispielsweise dritte Druckzuführungen, in der Vorrichtung vorhanden sein.

Die erste Druckzuführung ist mit einem ersten Druck beaufschlagbar. Unter einem ersten Druck kann prinzipiell ein beliebiger Druck des fluiden Mediums verstanden werden, prinzipiell kann auch ein Außendruck oder ein Referenzdruck, beispielsweise der Druck einer Außenluft, unter dem ersten Druck verstanden werden. Bevorzugt kann das Drucksensorelement über die erste Druckzuführung derart mit dem fluiden Medium, welches den ersten Druck aufweist, verbunden sein, dass der erste Druck von dem Drucksensorelement erfasst werden kann.

Über die zweite Druckzuführung ist das Drucksensorelement mit mindestens einem zweiten Druck beaufschlagbar. Der zweite Druck kann prinzipiell wie der erste Druck definiert werden. Der zweite Druck kann sich bevorzugt von dem ersten Druck unterscheiden, kann jedoch auch mit dem ersten Druck übereinstimmen, beispielsweise ebenfalls zur Durchführung einer Kalibration und/oder eines Abgleichs.

Das Trägerelement weist mindestens ein Substrat und mindestens eine Moldmasse auf. Das Substrat kann mindestens einen Schaltungsträger umfassen. Der Begriff "Schaltungsträger" bezeichnet grundsätzlich ein beliebiges Element, welches ausgestaltet sein kann, um mindestens eine Ansteuerung und/oder mindestens eine Auswerteschaltung, beispielsweise eine elektrische und/oder elektronische Schaltung, zu tragen und/oder zu umfassen. Bei dem Schaltungsträger kann es sich beispielsweise um einen Keramikschaltungsträger handeln. Der Schaltungsträger kann beispielsweise ganz oder teilweise als Leiterplatte ausgestaltet sein oder mindestens eine Leiterplatte umfassen. Auch andere Ausgestaltungen sind grundsätzlich denkbar.

Der Begriff "Moldmasse" bezeichnet grundsätzlich ein beliebiges Material, welches in einem Ausgangszustand einem Formgebungsprozess in einer Form oder einem Werkzeug unterzogen werden kann. Insbesondere kann es sich um ein aushärtbares Material oder Materialgemisch handeln, welche in einem Ausgangszustand geformt werden kann, um dann auszuhärten und formstabil zu bleiben. Insbesondere kann die Moldmasse mindestens einen Kunststoff oder ein Kunststoffgemisch oder auch mindestens ein Ausgangsmaterial für einen Kunststoff umfassen. Beispielsweise kann die Moldmasse mindestens ein Fließharz und/oder ein Kunstharz umfassen. Auch andere Materialien sind denkbar. Die Moldmasse kann eingerichtet sein, um das Substrat mitsamt den Bauelementen zumindest teilweise zu umschließen. Die Moldmasse kann eingerichtet sein, um die Bauelemente vor Beeinträchtigungen durch mechanische Beschädigung, Verschmutzung oder dergleichen zu schützen. Die Moldmasse kann derart ausgestaltet sein, dass die Membran zumindest teilweise von der Moldmasse unbedeckt ist.

Das Trägerelement weist weiterhin mindestens eine Durchlassöffnung auf, welche das Trägerelement vollständig durchdringt. Unter einer "Durchlassöffnung" kann insbesondere eine Öffnung verstanden werden, welche an mindestens zwei Seiten eine weitere Öffnung und/oder einen offenen Raum anschließt und/oder zumindest fluidisch verbunden ist. Beispielsweise kann die Durchlassöffnung eine Durchlassbohrung sein oder umfassen. Die Durchlassöffnung kann mindestens eine Aussparung der Moldmasse und mindestens ein Loch des Substrats umfassen. Das Loch kann grundsätzlich einen beliebigen Querschnitt aufweisen, beispielsweise einen runden, einen ovalen oder einen polygonalen Querschnitt. Auch andere Querschnitte sind grundsätzlich denkbar. Die Durchlassöffnung kann weiterhin mindestens einen Kanal umfassen, welcher durch die Moldmasse begrenzt ist. Unter einem "Kanal" ist insbesondere ein länglicher Hohlraum zu verstehen, der sich von mindestens einer ersten Öffnung hin zu mindestens einer zweiten Öffnung erstreckt. Der Kanal kann grundsätzlich einen beliebigen Querschnitt aufweisen, beispielsweise einen runden, einen ovalen oder einen polygonalen Querschnitt.

Der Begriff "Drucksensorelement" bezeichnet prinzipiell ein beliebiges Sensorelement, welches eingerichtet ist, um mindestens einen Druck eines fluiden Mediums zu erfassen. Bei dem Drucksensorelement kann es sich insbesondere um einen Chip handeln. Bei dem Drucksensorelement kann es sich beispielsweise um einen Drucksensor handeln, wie er aus Robert Bosch GmbH: Sensoren im Kraftfahrzeug, 1. Aufl. 2010, Seiten 80-82, bekannt ist. Bei dem Drucksensorelement kann es sich bevorzugt um einen Membransensor handeln, welcher insbesondere eine dünne Membran als mechanische Zwischenstufe aufweisen kann, welche beispielsweise einseitig dem Druck des fluiden Mediums ausgesetzt ist und sich unter diesem Einfluss mehr oder weniger durchbiegt. Auch andere Drucksensorelemente können prinzipiell alternativ oder zusätzlich eingesetzt werden, beispielsweise auf einem Piezoeffekt basierende Drucksensorelemente und/oder auf einer Dehnung mindestens eines dehnungsabhängigen elektrischen Widerstands basierende Drucksensorelemente.

Unter einer "Membran" im Sinne der vorliegenden Erfindung ist grundsätzlich ein beliebiges Element mit einer länglichen Form und einer Dicke zu verstehen, wobei eine Ausdehnung des Elements in der lateralen Dimension die Dicke des Elements überschreitet, beispielsweise um einen Faktor von 20, vorzugsweise um einen Faktor von 50 oder vorzugsweise um einen Faktor von 100. Die Membran kann ganz oder teilweise aus einem flexiblen Material oder ganz oder teilweise aus einem starren Material hergestellt sein. Weiterhin kann die Membran für unterschiedliche Stoffe unterschiedlich durchlässig gestaltet sein. Beispielsweise kann die Membran zumindest weitgehend undurchlässig für mindestens einen oder mehrere Stoffe sein. Beispielsweise kann die Membran für mindestens einen oder mehrere Stoffe in eine Richtung durchlässig sein. Beispielsweise kann die Membran für mindestens einen oder mehrere Stoffe in beide Richtungen durchlässig sein. Auch andere Ausführungsformen sind grundsätzlich möglich.

Das Drucksensorelement kann weiterhin ganz oder teilweise mit einem ersten Schutzmaterial abgedeckt sein. Das erste Schutzmaterial kann eingerichtet sein, um einen Schutz eines Drucksensorelements vor äußeren Einflüssen bereitzustellen. Beispielsweise kann das erste Schutzmaterial ein Gel umfassen und/oder eine andere verformbare Masse eines plastischen oder fließfähigen Materials.

Der Begriff "Steuer- und Auswerteeinheit" bezeichnet im Sinne der vorliegenden Erfindung eine elektrische und/oder elektronische Schaltung, welche eingerichtet ist, um mindestens ein Signal, insbesondere ein elektrisches Signal, zu detektieren und/oder einzustellen. Beispielsweise kann die Steuer- und Auswerteeinheit mindestens eine anwendungsspezifische integrierte Schaltung und/oder mindestens einen Kondensator aufweisen. Auch andere Ausgestaltungsformen sind grundsätzlich denkbar.

Das Substrat des Trägerelements kann Leiterbahnen umfassen. Der Begriff "Leiterbahnen" bezeichnet grundsätzlich elektrisch leitende Verbindungen mit zweidimensionalem Verlauf, beispielsweise in einer Ebene des Substrats. Leiterbahnen können zu einem Verbinden von elektronischen Bauteilen eingesetzt werden. Die Leiterbahnen können beispielsweise aus Gold hergestellt sein. Auch andere Materialien sind grundsätzlich denkbar. Das Sensorelement und die Steuer- und Auswerteeinheit können mit den Leiterbahnen verbunden sein. Insbesondere können das Sensorelement und/oder die Steuer- und Auswerteeinheit Bondpads aufweisen, welche elektrisch mit Bondflächen der Leiterbahnen verbunden sind.

Die Bondflächen der Leiterbahnen können zumindest teilweise durch ein zweites Schutzmaterial abgedeckt sein. Das zweite Schutzmaterial kann eingerichtet sein, um einen Schutz der Bondflächen von äußeren Einflüssen bereitzustellen. Das zweite Schutzmaterial kann beispielsweise ein Harz, insbesondere ein Epoxidharz, umfassen.

Die Bezeichnungen "erstes" und "zweites" Schutzmaterial sind wiederum als reine Bezeichnungen anzusehen, ohne eine Rangfolge anzugeben und beispielsweise ohne die Möglichkeit auszuschließen, dass mehrere Arten von ersten Schutzmaterialien und mehrere Arten von zweiten Schutzmaterialien oder jeweils genau eine Art vorgesehen sein kann. Weiterhin können zusätzliche Schutzmaterialien, beispielsweise dritte Schutzmaterialen, vorhanden sein.

Die Vorrichtung kann weiterhin mindestens einen elektrischen Anschluss umfassen, insbesondere mindestens einen Stecker. Das Sensormodul kann elektrisch mit dem elektrischen Anschluss verbunden sein. Das Sensormodul kann insbesondere durch mindestens eine Kontaktierung mit dem elektrischen Anschluss verbunden sein. Insbesondere kann die Kontaktierung einen elektrisch leitfähigen Klebstoff umfassen.

Weiterhin wird ein Verfahren zur Herstellung der Vorrichtung vorgeschlagen. Das Verfahren kann die Verfahrensschritte, welche im Folgenden beschrieben werden, umfassen. Die Verfahrensschritte können beispielsweise in der vorgegebenen Reihenfolge durchgeführt werden. Eine andere Reihenfolge ist jedoch ebenfalls denkbar. Weiterhin können ein oder mehrere Verfahrensschritte gleichzeitig oder zeitlich überlappend durchgeführt werden. Weiterhin können einer, mehrere oder alle der Verfahrensschritte einfach oder auch wiederholt durchgeführt werden. Das Verfahren kann darüber hinaus noch weitere Verfahrensschritte umfassen.

Das Verfahren zur Herstellung der Vorrichtung nach der vorliegenden Erfindung, wie nach einer der Ausführungsformen, die oben bereits ausgeführt wurden oder im Folgenden beschrieben werden, umfasst die folgenden Schritte:
a) Bereitstellen eines ersten Gehäuseteils eines Gehäuses;
b) Einbringen des Sensormoduls in das erste Gehäuseteil; und
c) Aufbringen eines zweiten Gehäuseteils des Gehäuses.

Der Schritt b) kann ein formschlüssiges Verbinden des Sensormoduls mit dem ersten Gehäuseteil umfassen, insbesondere ein Einkleben des Sensormoduls in das erste Gehäuseteil. Der Schritt b) kann weiterhin ein Einbringen mindestens eines Abdichtungsmaterials zwischen das erste Gehäuseteil und dem Sensormodul umfassen. Das Sensormodul kann einstückig in das erste Gehäuseteil eingebracht werden. Der Schritt b) kann weiterhin ein Herstellen einer elektrischen Verbindung zwischen dem Sensormodul und mindestens einem elektrischen Anschluss der Vorrichtung umfassen. Das Herstellen der elektrischen Verbindung kann mittels mindestens eines elektrisch leitfähigen Klebstoffs erfolgen.

Schritt c) kann ein Einbringen mindestens eines Abdichtungsmaterials zwischen dem Sensormodul und dem ersten Gehäuseteil umfassen.

Die vorgeschlagene Vorrichtung zur Erfassung eines Drucks eines fluiden Mediums sowie das Verfahren zur Herstellung der Vorrichtung weisen gegenüber bekannten Vorrichtungen und Verfahren zahlreiche Vorteile auf. Durch eine Verwendung des Trägerelements, welches das Substrat und die Moldmasse umfasst, kann sich insbesondere ein signifikantes Einsparpotenzial gegenüber einem Keramikträger ergeben, da sich ein Flächenbedarf grundsätzlich etwa um die Hälfte senken kann. Das Sensormodul kann insbesondere einen technischen Vorteil aufweisen, da die anwendungsspezifische integrierte Schaltung und die Kondensatoren in der Moldmasse eingespritzt und damit vor Medien geschützt sind. Insbesondere kann nur noch eine Montierung des Drucksensorelements auf die Durchlassöffnung des Trägerelements notwendig sein. Das Drucksensorelement kann insbesondere ein Chip mit einer Membran und mit Goldbondpads sein, welche insbesondere gut vor aggressiven Medien geschützt sein können.

Beim Einbringen des Sensormoduls in das Gehäuse, insbesondere in das erste Gehäuseteil, kann das Sensormodul mit Hilfe des Abdichtungsmaterials, insbesondere des Dichtklebstoffs und/oder Leitklebstoffs, gleichzeitig in das Gehäuse eingebaut und kontaktiert werden. Dadurch, dass die Abdichtungsmaterialien einen ähnlichen Temperaturausdehnungskoeffizienten haben können, können mechanische Verspannungen, die sich auf das Sensormodul auswirken könnten, vermieden werden. Wird zum Einbringen des Sensormoduls in das Gehäuse mindestens ein Leitklebstoff verwendet, so kann durch den Leitklebstoff beispielsweise eine direkte elektrische Kontaktierung in einer Klebe- und Fügefläche hergestellt werden. Beispielsweise kann mittels des mindestens einen Leitklebstoffs eine direkte elektrische Kontaktierung mit dem mindestens einen elektrischen Anschluss, welcher unten noch näher erläutert wird, hergestellt werden.

Für das Aufbringen des zweiten Gehäuseteils kann das gleiche Abdichtungsmaterial, insbesondere der gleiche Dichtklebstoff, wie für das Einkleben des Sensormoduls verwendet werden und in Form einer Acht quer über das Modul geführt werden, so dass hierdurch zwei getrennte Kammern entstehen können. Durch den beschriebenen Aufbau der Vorrichtung kann insbesondere ein Kostenvorteil besonders gut zur Geltung kommen.

Das Sensormodul mit den Goldbondpads, insbesondere medienbeständigen Goldbondpads, kann innerhalb der Aussparung der Moldmasse auf den durch die Moldmasse gebildeten Kanal aufgeklebt werden und durch die Bonddrähte, insbesondere durch Goldbonddrähte, mit den Leiterbahnen auf der Leiterplatte verbunden sein. Die hierfür freistehenden Bondflächen auf der Leiterplatte und die Bondpads können nach einem Bondprozess durch das zweite Schutzmaterial, insbesondere durch einen diffusionsdichten Epoxidharzverguss, geschützt sein. Die Bonddrähte und das Drucksensorelement können in der Aussparung durch das erste Schutzmaterial, insbesondere durch ein druckübertragendes Gel, bedeckt sein. Die anwendungsspezifische integrierte Schaltung kann zur Signalauswertung eingerichtet sein und kann ganz oder zumindest teilweise mit den Bonddrähten in der Moldmasse eingebettet sein und von einem Messmedium, beispielsweise Abgas, geschützt werden. Ebenso können die Kondensatoren in der Moldmasse eingebettet sein.

Da Kontaktflächen des Sensormoduls nach dem Einbringen in das erste Gehäuseteil im Allgemeinen von oben her nicht zugänglich sein können, können sie grundsätzlich nicht mit üblichen Verfahren, wie beispielsweise Löten oder Drahtbonden, mit Steckerkontakten des Gehäuses verbunden werden. Stattdessen kann das Abdichtungsmaterial und der elektrische Anschluss mit einem Leitklebstoff oder einer leitenden Klebefolie gleichzeitig in einem Arbeitsgang hergestellt werden.

Dadurch kann das Verfahren zum Herstellen der Vorrichtung grundsätzlich wesentlich vereinfacht werden. Bisher wurde eine Klebung des Sensormoduls grundsätzlich erst ausgehärtet, um den anschließenden Bondprozess zu ermöglichen. Im Rahmen des erfindungsgemäßen Verfahrens können erst nacheinander das Abdichtungsmaterial zu einer Abdichtung des Gehäuses und der leitfähige Klebstoff angebracht, dann das Sensormodul aufgesetzt und dann das Abdichtungsmaterial zu einer Abdichtung des zweiten Gehäuseteils aufgebracht werden. Alle Abdichtungsmaterialen und/oder leitfähigen Klebstoffe können gemeinsam ausgehärtet werden.

### Kurze Beschreibung der Figuren

Weitere optionale Einzelheiten und Merkmale der Erfindung ergeben sich aus der nachfolgenden Beschreibung bevorzugter Ausführungsbeispiele, welche in den Figuren schematisch dargestellt sind.

Es zeigen:
- Figur 1A und 1B: eine Schnittdarstellung eines Ausführungsbeispiels eines in einer erfindungsgemäßen Vorrichtung einsetzbaren Sensormoduls (Figur 1A) und eine Darstellung eines Schaltbilds eines in einer erfindungsgemäßen Vorrichtung einsetzbaren Sensormoduls (Figur 1B);
- Figur 2: eine Darstellung eines Ausführungsbeispiels einer erfindungsgemäßen Vorrichtung zur Erfassung eines Drucks eines fluiden Mediums,
- Figur 3: eine Draufsicht auf ein weiteres Ausführungsbeispiel ohne zweites Gehäuseteil und ohne Drucksensormodul,
- Figur 4: eine Draufsicht auf das weitere Ausführungsbeispiel ohne zweites Gehäuseteil und mit Drucksensormodul, und
- Figur 5: eine Schnittansicht des weiteren Ausführungsbeispiels.

### Ausführungsformen der Erfindung

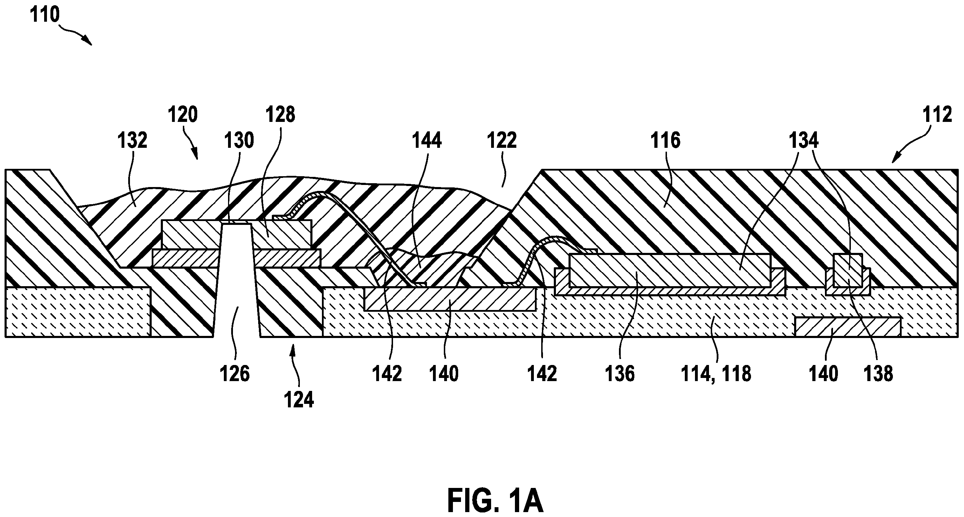

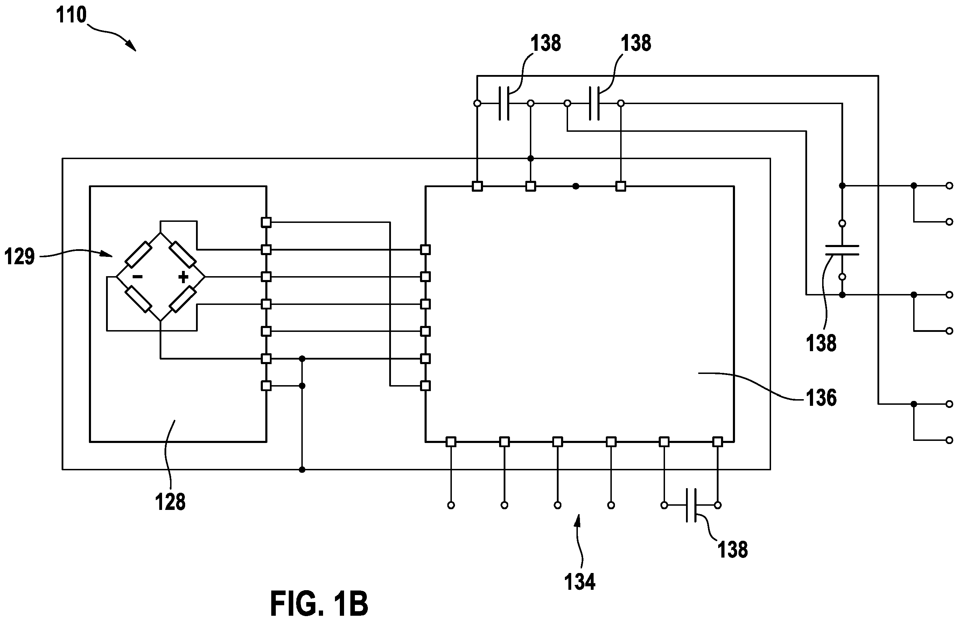

Figur 1A zeigt ein exemplarisches Ausführungsbeispiel eines Sensormoduls 110. Das Sensormodul 110 ist in Figur 1A in einer Schnittdarstellung gezeigt. Figur 1B zeigt ein exemplarisches Schaltbild des Sensormoduls 110.

Das Sensormodul 110 umfasst mindestens ein Trägerelement 112, welches mindestens ein Substrat 114 und mindestens eine Moldmasse 116 aufweist. Die Moldmasse 116 liegt vorzugsweise im Gebrauch des Sensormoduls 110 in einem ausgehärteten Zustand vor. Das Substrat 114 kann beispielsweise eine Leiterplatte 118 umfassen. Das Substrat 114 kann weiterhin eine quaderförmige oder plattenförmige Grundform aufweisen. Auch eine Folienform ist denkbar. Das Substrat 114 kann beispielsweise ganz oder teilweise aus einem Keramikmaterial hergestellt sein. Auch andere Materialien sind grundsätzlich denkbar, beispielsweise ein glasfaserverstärktes Kunststoffmaterial und/oder ein Polyimid.

Die Moldmasse 116 kann beispielsweise ein Fließ- oder Kunstharz umfassen und kann eingerichtet sein, um das Substrat 114 zumindest teilweise zu umschließen.

Das Trägerelement 112 weist weiterhin mindestens eine Durchlassöffnung 120 auf, welche das Trägerelement 112 vollständig durchdringt. Die Durchlassöffnung 120 des Trägerelements 112 kann mindestens eine Aussparung 122 der Moldmasse und mindestens eine Öffnung 124 des Substrats 114 umfassen. Die Durchlassöffnung kann weiterhin mindestens einen Kanal 126 umfassen, welcher durch die Moldmasse 116 begrenzt ist.

Das Sensormodul 110 weist weiterhin mindestens ein Drucksensorelement 128 zur Erfassung des Drucks auf. Das Drucksensorelement 128 umfasst mindestens eine Membran 130. Das Drucksensorelement 128 deckt die Durchlassöffnung 120 ab. Das Drucksensorelement 128 kann ganz oder teilweise mit einem ersten Schutzmaterial 132 abgedeckt sein. Das erste Schutzmaterial 132 kann eingerichtet sein, um einen Schutz des Drucksensorelements 128 vor äußeren Einflüssen bereitzustellen. Das erste Schutzmaterial 132 kann insbesondere ein Gel umfassen.

Das Sensormodul 110 kann weiterhin mindestens eine Steuer- und Auswerteeinheit 134 umfassen. Die Steuer- und Auswerteeinheit 134 kann eingerichtet sein, um mindestens ein Signal zu detektieren und/oder einzustellen. Die Steuer- und Auswerteeinheit 134 ist zumindest teilweise von der Moldmasse 116 umschlossen. Die Steuer- und Auswerteeinheit 134 kann insbesondere mindestens eine anwendungsspezifische integrierte Schaltung 136 (ASIC) und/oder mindestens einen Kondensator 138 aufweisen.

Das Substrat 114 kann Leiterbahnen 140 umfassen. Die Leiterbahnen 140 können aus Gold hergestellt sein. Das Drucksensorelement 128 und die Steuer- und Auswerteeinheit 134 können mit den Leiterbahnen 140 verbunden sein. Beispielsweise können das Drucksensorelement 128 und die Steuer- und Auswerteeinheit 134 Bondpads aufweisen, welche elektrisch durch Bonddrähte 142 mit Bondflächen der Leiterbahnen 140 verbunden sind.

Die Bondflächen der Leiterbahnen 140 können zumindest teilweise durch ein zweites Schutzmaterial 144 abgedeckt sein. Das zweite Schutzmaterial 144 kann eingerichtet sein, um einen Schutz der Bondflächen vor äußeren Einflüssen bereitzustellen. Insbesondere kann das zweite Schutzmaterial 144 ein Harz, insbesondere ein Epoxidharz, umfassen.

Figur 1B zeigt ein exemplarisches Schaltbild des Sensormoduls 110. Das Sensormodul 110 kann beispielsweise dem in Figur 1B vorgeschlagenen Sensormodul 110 entsprechen, so dass weitgehend auf die obige Beschreibung verwiesen werden kann. Das Sensormodul 110 umfasst mindestens ein Drucksensorelement 128 und mindestens eine Steuer- und Auswerteeinheit 134. Wie in der Figur 1B angedeutet, kann das Drucksensorelement beispielsweise auf mindestens einem durch den Druck beeinflussbaren Druck- oder Dehnungsabhängigen elektrischen Widerstand basieren, welcher beispielsweise mittels mindestens einer Brückenschaltung 129 ausgewertet wird, um ein Drucksignal zu erzeugen oder zu erfassen. Die Steuer- und Auswerteeinheit 134 kann, wie oben ausgeführt, mindestens eine anwendungsspezifische integrierte Schaltung 136 und beispielsweise mindestens vier Kondensatoren 138 aufweisen. Es wird darauf hingewiesen, dass im Rahmen der vorliegenden Erfindung grundsätzlich auch andere Druckmessprinzipien und dementsprechend auch andere Arten von Drucksensorelementen 128 und/oder Steuer- und Auswerteeinheiten 134 eingesetzt werden können. Es können ein oder mehrere Drucksensorelemente 128 mit einen oder mehreren anwendungsspezifischen integrierten Schaltungen (ASIC) 136 verbunden sein. Alternativ oderzusätzlich kann das Sensormodul 110 weiterhin ein Temperatursensorelement, beispielsweise ein NTC-Widerstand, umfassen.

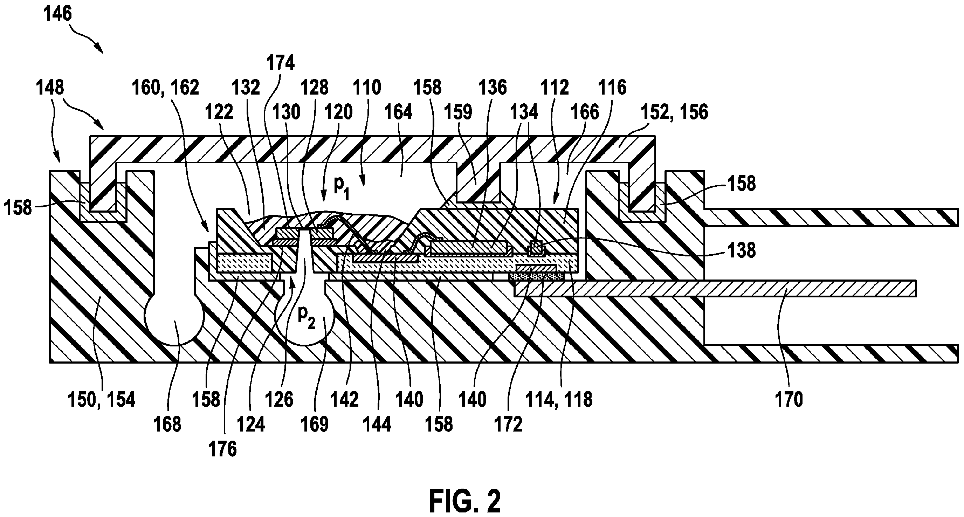

Figur 2 zeigt ein exemplarisches Ausführungsbeispiel einer erfindungsgemäßen Vorrichtung 146 zur Erfassung eines Drucks eines fluiden Mediums. Die Vorrichtung 146 ist in Figur 2 in einer Schnittdarstellung gezeigt. Die Vorrichtung 146 umfasst mindestens ein Sensormodul 110. Das Sensormodul 110 entspricht der Anordnung gemäß Figur 1A, so dass weitgehend auf die Beschreibung der Figur 1A oben verwiesen werden kann.

Die Vorrichtung 146 umfasst mindestens ein Gehäuse 148. Das Gehäuse 148 umfasst ein erstes Gehäuseteil 150 und mindestens ein zweites Gehäuseteil 152. Insbesondere kann das erste Gehäuseteil 150 eine Gehäusebasis 154 sein. Weiterhin kann das zweite Gehäuseteil 152 insbesondere ein Gehäusedeckel 156 sein. Das erste Gehäuseteil 150 und das zweite Gehäuseteil 152 sind stoffschlüssig miteinander verbunden. Die Vorrichtung 146 kann mindestens ein Abdichtungsmaterial 158 umfassen. Das Abdichtungsmaterial 158 kann insbesondere eingerichtet sein, um das erste Gehäuseteil 150 und das zweite Gehäuseteil 152 miteinander zu verbinden. Weiterhin kann das Abdichtungsmaterial 158 eingerichtet sein, um das Sensormodul 110 mit dem Gehäuse 148 zu verbinden.

Das Gehäuse 148 kann mindestens eine Aufnahme 160 zum Aufnehmen des Sensormoduls 110 umfassen. Insbesondere kann die Aufnahme 116 eine Vertiefung 162 sein. Das Sensormodul 110 kann mittels des Abdichtungsmaterials 158 in der Aufnahme 160 befestigt sein. Um die mindestens eine Leiterbahn 140 elektrisch beim Einfügen des Sensormoduls 110 in das erste Gehäuseteil 150, beispielsweise in die Aufnahme 160, elektrisch zu kontaktieren und beispielsweise elektrisch mit mindestens einem elektrischen Anschluss 170 zu verbinden, kann das Abdichtungsmaterial 158 ganz oder teilweise elektrisch leitfähige Eigenschaften aufweisen und/oder kann durch mindestens einen elektrisch leitfähigen Klebstoff 172 ergänzt werden, wie in Figur 2 angedeutet. Dieser elektrisch leitfähige Klebstoff kann beispielsweise ganz oder teilweise als elektrisch leitfähige Klebstoffmasse und/oder als elektrisch leitfähige Klebefolie ausgestaltet sein.

Das Gehäuse 148 kann mindestens einen Druckraum 164 und mindestens einen Schaltungsraum 166 umschließen. Der Druckraum 164 kann gegenüber dem Schaltungsraum 166 abgedichtet sein, beispielsweise durch das Abdichtungsmaterial 158 und/oder mindestens einen Steg 159, der beispielsweise von dem Gehäusedeckel 156 aus auf das Sensormodul 110 aufgesetzt ist und gegen das Sensormodul 110 durch das Abdichtungsmaterial 158 abgedichtet ist. Mittels dieses Stegs 159 kann somit das Sensormodul 110 zusätzlich mechanisch fixiert werden. In dem Schaltungsraum 166 kann mindestens ein elektrisches Bauteil aufgenommen sein. Das Sensormodul 110 kann teilweise in dem Druckraum 164 und teilweise in dem Schaltungsraum 166 angeordnet sein und gegen das Gehäuse 148 abgedichtet sein. Beispielsweise kann in dem dargestellten Beispiel der mindestens eine Kondensator 138 in dem Schaltungsraum 166 angeordnet sein.

Das Gehäuse 148 umfasst weiterhin mindestens zwei Druckzuführungen 168, 169. So kann beispielsweise eine erste Druckzuführung 168 mit dem Druckraum 164 verbunden sein und eine zweite Druckzuführung 169 mit dem Kanal 126. So kann das Drucksensorelement 128 von der Oberseite 174 her über die erste Druckzuführung 168 mit einem ersten Druck p₁ beaufschlagt werden und von der Unterseite 176 her über die zweite Druckzuführung 169 mit einem zweiten Druck p₂. Das Drucksensorelement 128 kann sich so beispielsweise entsprechend der Differenz p₁-p₂ verformen, wobei die Verformung elektrisch erfassbar ist.

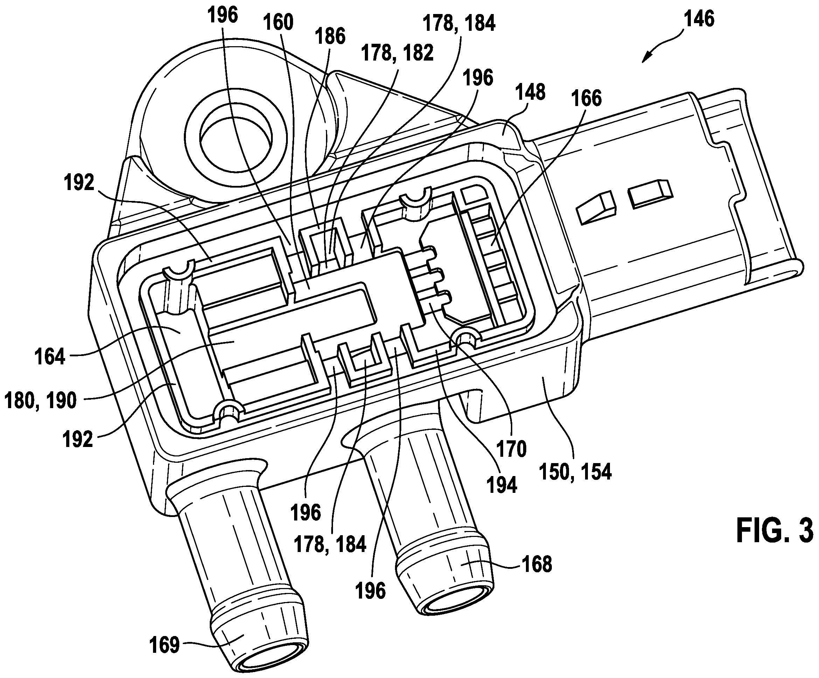

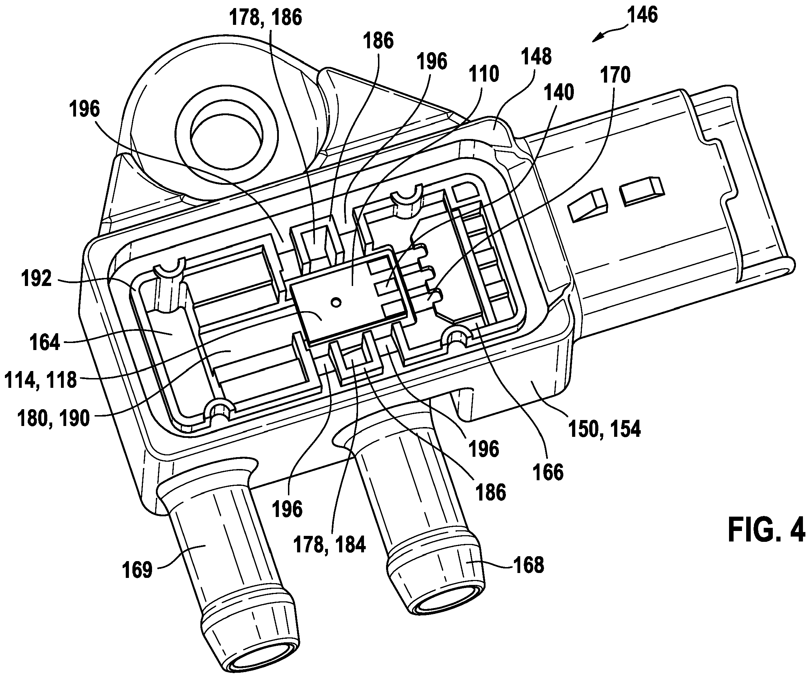

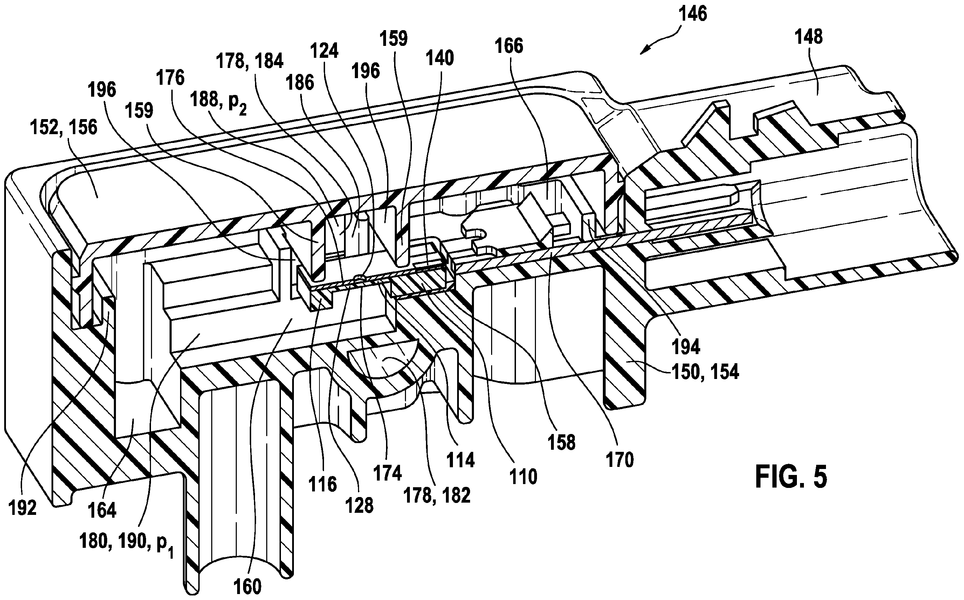

Die Figuren 3, 4 und 5 zeige ein weiteres exemplarisches Ausführungsbeispiel einer erfindungsgemäßen Vorrichtung 146 zur Erfassung eines Drucks eines fluiden Mediums. Nachstehend werden lediglich die Unterschiede zu den vorhergehenden Ausführungsbeispielen beschrieben und gleiche Bauteile sind mit gleichen Bezugszeichen versehen. Figur 3 zeigt eine Draufsicht auf die Vorrichtung 146 ohne zweites Gehäuseteil 152 bzw. Gehäusedeckel 156 und ohne Sensormodul 110. Figur 4 zeigt eine Draufsicht auf die Vorrichtung 146 ohne zweites Gehäuseteil 152 bzw. Gehäusedeckel 156 und mit Sensormodul 110. Figur 5 zeigt eine Schnittansicht der Vorrichtung 146.

Im Vergleich zu den vorherigen Ausführungsbeispielen wird das Sensormodul 110 invertiert in dem Gehäuse 148 angeordnet wie nachstehend ausführlicher beschrieben wird. Dabei ist das Drucksensormodul 110 mittels des Abdichtungsmaterials 158 mit dem ersten Gehäuseteil 150 verbunden. Genauer ist das Abdichtungsmaterial 158 mit der Moldmasse 116 und dem ersten Gehäuseteil 150 verbunden. Wie zuvor beschrieben weist das Drucksensorelement 128 eine Oberseite 174 und eine Unterseite 176 auf. Die Membran 130 befindet sich dabei auf der Oberseite 174. Die Unterseite 176 ist dem Substrat 114 zugewandt. Wie in Figur 3 gut zu erkennen ist, ist in dem ersten Gehäuseteil 150 bzw. der Gehäusebasis 154 ein erster Druckkanal 178 und ein zweiter Druckkanal 180 ausgebildet. Der erste Druckkanal 178 ist mit der ersten Druckzuführung 168 verbunden und der zweite Druckkanal 180 ist mit der zweiten Druckzuführung 169 verbunden.

Wie in Figur 4 und 5 gut zu erkennen ist, ist das Drucksensormodul 110 derart in dem Gehäuse 148 aufgenommen, dass die Oberseite 174 ersten Gehäuseteil 150 bzw. der Gehäusebasis 15 zugewandt ist. Der erste Druckkanal 178 ist derart ausgebildet, dass das Drucksensorelement 128 von der Unterseite 176 her mit einem ersten Druck p₁ beaufschlagbar ist, wie nachstehend ausführlicher beschrieben ist. Der zweite Druckkanal 180 ist derart ausgebildet, dass das Drucksensorelement 128 von der Oberseite 174 her mit einem zweiten Druck p₂ beaufschlagbar ist, wie nachstehend ausführlicher beschrieben ist. Der erste Druckkanal 178 ist im Wesentlichen U-förmig mit einem Bodenabschnitt 182 und zwei Schenkelabschnitten 184 ausgebildet. Die Schenkelabschnitte 184 sind senkrecht zu dem Bodenabschnitt 182 orientiert. Bezogen auf die Darstellung der Figur 3 erstrecken sich die Schenkelabschnitte 184 nach oben. Die Schenkelabschnitte 184 verlaufen dabei seitlich neben der Aufnahme 160 und sind von Wänden 186 begrenzt. Dadurch befindet sich in einem eingesetzten Zustand das Drucksensormodul 110 zwischen den Schenkelabschnitten 184, wie in Figur 4 gut zu erkennen ist. Die Schenkelabschnitte 184 sind dabei seitlich neben dem Drucksensormodul 110 ausgebildet. Die Schenkelabschnitte 184 sind mit einer Länge ausgebildet, dass sie in einem Raum 188 oberhalb des Drucksensormoduls 110 bezogen auf die Darstellung der Figur 4 münden. Dadurch kann ein fluides Medium durch die erste Druckzuführung 168 in den ersten Druckkanal 178 und genauer von seitlich bezogen auf das Gehäuse 148 in den Bodenabschnitt 182 gelangen. Von dem Bodenabschnitt 182 kann das fluide Medium in die Schenkelabschnitte 184 gelangen. Von den Schenkelabschnitten 184 kann das fluide Medium in den Raum 188 gelangen. Da das Drucksensormodul 110 invertiert in dem Gehäuse 148 im Vergleich zu den vorherigen Ausführungsbeispielen angeordnet ist, kann das fluide Medium aus dem Raum 188 durch die Öffnung 124 in dem Substrat 114 und den Kanal 126 in der Moldmasse 116 zu der Unterseite 176 des Drucksensorelements 128 gelangen.

Der zweite Druckkanal 180 erstreckt sich zwischen den zwei Schenkelabschnitten 184 hindurch. Bezogen auf die Darstellung der Figur 3 ist der zweite Druckkanal 180 baulich und räumlich von dem ersten Druckkanal 178 getrennt. Der zweite Druckkanal 180 erstreckt sich bezogen auf die Darstellung der Figur 3 oberhalb des Bodenabschnitts 182 des ersten Druckkanals 178. So ist der zweite Druckkanal 180 in dem Gehäuseraum 164 ausgebildet und erstreckt sich geradlinig in die Aufnahme 160 hinein. Dabei ist zweite Druckkanal 180 als Vertiefung 190 in der Aufnahme 160 ausgebildet. Dadurch kann ein fluides Medium durch die zweite Druckzuführung 169 in den zweiten Druckkanal 180 und genauer von seitlich bezogen auf die Darstellung der Figur 3 zunächst in den Druckraum 164 gelangen. Von dem Druckraum 164 kann das fluide Medium in den zweiten Druckkanal 180 gelangen. Da das Drucksensormodul 110 invertiert in dem Gehäuse 148 im Vergleich zu den vorherigen Ausführungsbeispielen angeordnet ist, kann das fluide Medium von dem zweiten Druckkanal 180 zu der Oberseite 176 des Drucksensorelements 128 gelangen.

Wie weiterhin aus Figur 3 zu erkennen ist, ist der Druckraum 164 von Wänden 192 seitlich begrenzt. Der Schaltungsraum 166 ist ebenfalls von Wänden 194 seitlich begrenzt. Die Wände 192 des Druckraums 164 und die Wände 194 des Schaltungsraums 166 sind dabei von den Wänden 186 der Schenkelabschnitte 184 jeweils durch einen Spalt 196 beabstandet. Der Druckraum 164 kann gegenüber dem Schaltungsraum 166 abgedichtet sein, beispielsweise durch das Abdichtungsmaterial 158 und/oder zwei Stege 159, die beispielsweise von dem Gehäusedeckel 156 aus auf das Sensormodul 110 aufgesetzt sind und gegen das Sensormodul 110 durch das Abdichtungsmaterial 158 abgedichtet sind. Dabei greift jeweils ein Steg 159 in jeweils einen Spalt 196. Mittels der Stege 159 kann somit das Sensormodul 110 zusätzlich mechanisch fixiert werden. In dem Schaltungsraum 166 kann mindestens ein elektrisches Bauteil aufgenommen sein. Das Sensormodul 110 kann teilweise in dem Druckraum 164 und teilweise in dem Schaltungsraum 166 angeordnet sein und gegen das Gehäuse 148 abgedichtet sein. Beispielsweise kann in dem dargestellten Beispiel der mindestens eine Kondensator 138 in dem Schaltungsraum 166 angeordnet sein. Um die mindestens eine Leiterbahn 140 elektrisch nach dem Einfügen des Sensormoduls 110 in das erste Gehäuseteil 150, beispielsweise in die Aufnahme 160, elektrisch zu kontaktieren und beispielsweise elektrisch mit mindestens einem elektrischen Anschluss 170 zu verbinden, kann aufgrund der invertierten Anordnung des Sensormoduls 110 die Leiterbahn 140 mit dem Anschluss 170 mittels eines nicht näher gezeigten Bonddrahts verbunden werden, da ein Zugriff auf die Leiterbahn 140 bezogen auf die Darstellung der Figuren 4 und 5 von oben her möglich ist.

## Patentansprüche

1. Vorrichtung (146) zur Erfassung eines Drucks eines fluiden Mediums,
wobei die Vorrichtung (146) umfasst:
- mindestens ein Gehäuse (148) mit mindestens zwei Druckzuführungen (168, 169);
- mindestens ein Sensormodul (110), wobei das Sensormodul (110) in dem Gehäuse (148) aufgenommen ist, wobei das Sensormodul (110) umfasst:
• mindestens ein Trägerelement (112), wobei das Trägerelement (112) mindestens ein Substrat (114) und mindestens eine Moldmasse (116) aufweist, wobei das Trägerelement (112) weiterhin mindestens eine Durchlassöffnung (120) aufweist, wobei die Durchlassöffnung (120) das Trägerelement (112) vollständig durchdringt;
• mindestens ein Drucksensorelement (128) zur Erfassung des Drucks, wobei das Drucksensorelement (128) mindestens eine Membran umfasst, wobei das Drucksensorelement (128) die Durchlassöffnung (120) abdeckt;
**dadurch gekennzeichnet, dass** das Sensormodul (110) weiterhin mindestens eine Steuer- und Auswerteeinheit (134) aufweist,
wobei die Steuer- und Auswerteeinheit (134) mindestens eine anwendungsspezifische integrierte Schaltung aufweist und zumindest teilweise von der Moldmasse (116) umschlossen ist, wobei das Gehäuse (148) mindestens ein erstes Gehäuseteil (150) und mindestens ein zweites Gehäuseteil (152) umfasst, wobei das erste Gehäuseteil (150) und das zweite Gehäuseteil (152) stoffschlüssig miteinander verbunden sind,
wobei das Drucksensorelement (128) eine Oberseite (174) und eine Unterseite (176) aufweist, wobei sich die Membran (130) auf der Oberseite (174) befindet, wobei die Unterseite (176) dem Substrat (114) zugewandt ist, wobei das Sensormodul (110) so in dem Gehäuse (148) aufgenommen ist, dass die Oberseite (174) dem ersten Gehäuseteil (150) zugewandt ist,
wobei in dem ersten Gehäuseteil (150) ein erster Druckkanal (178) und ein zweiter Druckkanal (180) ausgebildet ist, wobei der erste Druckkanal (178) mit einer ersten Druckzuführung (168) verbunden ist und der zweite Druckkanal (180) mit einer zweiten Druckzuführung (169) verbunden ist, wobei der erste Druckkanal (178) derart ausgebildet ist, dass das Drucksensorelement (128) von der Unterseite (176) her mit einem ersten Druck (p1) beaufschlagbar ist,
wobei der zweite Druckkanal (180) derart ausgebildet ist,
dass das Drucksensorelement (128) von der Oberseite (174) her mit einem zweiten Druck (p2) beaufschlagbar ist, und dass der erste Druckkanal (178) im Wesentlichen U-förmig mit einem Bodenabschnitt (182) und zwei Schenkelabschnitten (184) ausgebildet ist, wobei sich der zweite Druckkanal (180) zwischen den zwei Schenkelabschnitten (184) hindurch erstreckt.

2. Vorrichtung (146) nach einem der vorhergehenden Ansprüche, wobei die Moldmasse (116) derart ausgestaltet ist, dass die Membran (130) des Drucksensorelements (128) zumindest teilweise von der Moldmasse (116) unbedeckt ist.

3. Vorrichtung (146) nach einem der vorhergehenden Ansprüche, wobei das Drucksensorelement (128) ganz oder teilweise mit einem ersten Schutzmaterial (132) abgedeckt ist, wobei das erste Schutzmaterial (132) eingerichtet ist, um einen Schutz des Drucksensorelements (128) vor äußeren Einflüssen bereitzustellen.

4. Vorrichtung (146) nach einem der vorhergehenden Ansprüche, wobei die Vorrichtung (146) weiterhin mindestens ein Abdichtungsmaterial (158) umfasst, wobei das Abdichtungsmaterial (158) eingerichtet ist, um das erste Gehäuseteil (150) und das zweite Gehäuseteil (152) miteinander zu verbinden und um das Sensormodul (110) mit dem Gehäuse (148) zu verbinden.

5. Vorrichtung (146) nach dem vorhergehenden Anspruch, wobei das Gehäuse (148) mindestens eine Aufnahme (160) zum Aufnehmen des Sensormoduls (110) umfasst, wobei das Sensormodul (110) mittels des Abdichtungsmaterials (158) in der Aufnahme (160) befestigt ist.

6. Vorrichtung (146) nach einem der vorhergehenden Ansprüche, wobei das Gehäuse (148) mindestens einen Druckraum (164) und mindestens einen Schaltungsraum (166) umschließt, wobei der Druckraum (164) gegenüber dem Schaltungsraum (166) abgedichtet ist, und wobei in dem Schaltungsraum (166) mindestens ein elektrisches Bauteil aufgenommen ist, wobei das Sensormodul (110) teilweise in dem Druckraum (164) und teilweise in dem Schaltungsraum (166) angeordnet ist und gegen das Gehäuse (148) abgedichtet ist.

7. Vorrichtung (146) nach einem der vorhergehenden Ansprüche, wobei die Vorrichtung (146) weiterhin mindestens einen elektrischen Anschluss (170) umfasst, wobei das Sensormodul (110) durch mindestens einen leitfähigen Klebstoff (172) elektrisch mit dem elektrischen Anschluss (170) verbunden ist.

8. Vorrichtung (146) nach dem vorhergehenden Anspruch, wobei der leitfähige Klebstoff (172) eingerichtet ist, um eine direkte elektrische Kontaktierung mit dem elektrischen Anschluss (170) zu bilden.

9. Verfahren zur Herstellung der Vorrichtung (146) nach einem der vorhergehenden Ansprüche, umfassend die folgenden Schritte:
a) Bereitstellen eines ersten Gehäuseteils (150) des Gehäuses (148);
b) Einbringen des Sensormoduls (110) in das erste Gehäuseteil (150); und
c) Aufbringen eines zweiten Gehäuseteils (152) des Gehäuses (148).

10. Verfahren nach dem vorhergehenden Verfahrensanspruch, wobei Schritt b) eine formschlüssige Verbindung des Sensormoduls (110) mit dem ersten Gehäuseteil (150) umfasst.

11. Verfahren nach einem der beiden vorhergehenden Verfahrensansprüche, wobei Schritt b) ein Einbringen mindestens eines Abdichtungsmaterials (158) zwischen das erste Gehäuseteil (150) und das Sensormodul (110) umfasst.

## Claims

1. Apparatus (146) for the detection of a pressure of a fluid medium, the apparatus (146) comprising:
- at least one housing (148) with at least two pressure feed lines (168, 169);
- at least one sensor module (110), the sensor module (110) being received in the housing (148), the sensor module (110) comprising:
• at least one carrier element (112), the carrier element (112) having at least one substrate (114) and at least one moulding compound (116), the carrier element (112) having, furthermore, at least one passage opening (120), the passage opening (120) penetrating the carrier element (112) completely;
• at least one pressure sensor element (128) for the detection of the pressure, the pressure sensor element (128) comprising at least one membrane, the pressure sensor element (128) covering the passage opening (120);
**characterized in that**, furthermore, the sensor module (110) has at least one control and evaluation unit (134), the control and evaluation unit (134) having at least one application-specific integrated circuit and being enclosed at least partially by the moulding compound (116), the housing (148) comprising at least one first housing part (150) and at least one second housing part (152), the first housing part (150) and the second housing part (152) being connected to one another in an integrally joined manner, the pressure sensor element (128) having an upper side (174) and a lower side (176), the membrane (130) being situated on the upper side (174), the lower side (176) facing the substrate (114), the sensor module (110) being received in the housing (148) in such a way that the upper side (174) faces the first housing part (150), a first pressure duct (178) and a second pressure duct (180) being configured in the first housing part (150), the first pressure duct (178) being connected to a first pressure feed line (168), and the second pressure duct (180) being connected to a second pressure feed line (169), the first pressure duct (178) being configured in such a way that the pressure sensor element (128) can be loaded from the lower side (176) with a first pressure (p1), the second pressure duct (180) being configured in such a way that the pressure sensor element (128) can be loaded from the upper side (174) with a second pressure (p2), and **in that** the first pressure duct (178) is of substantially U-shaped configuration with a bottom section (182) and two limb sections (184), the second pressure duct (180) extending through between the two limb sections (184).

2. Apparatus (146) according to one of the preceding claims, the moulding compound (116) being configured in such a way that the membrane (130) of the pressure sensor element (128) is uncovered at least partially by the moulding compound (116).

3. Apparatus (146) according to either of the preceding claims, the pressure sensor element (128) being covered entirely or partially with a first protective material (132), the first protective material (132) being set up to provide protection for the pressure sensor element (128) against external influences.

4. Apparatus (146) according to one of the preceding claims, the apparatus (146) comprising, furthermore, at least one sealing material (158), the sealing material (158) being set up to connect the first housing part (150) and the second housing part (152) to one another and to connect the sensor module (110) to the housing (148) .

5. Apparatus (146) according to the preceding claim, the housing (148) comprising at least one receptacle (160) for receiving the sensor module (110), the sensor module (110) being fastened in the receptacle (160) by means of the sealing material (158).

6. Apparatus (146) according to one of the preceding claims, the housing (148) enclosing at least one pressure space (164) and at least one circuit space (166), the pressure space (164) being sealed with respect to the circuit space (166), and at least one electric component being received in the circuit space (166), the sensor module (110) being arranged partially in the pressure space (164) and partially in the circuit space (166) and being sealed with respect to the housing (148).

7. Apparatus (146) according to one of the preceding claims, the apparatus (146) comprising, furthermore, at least one electric connector (170), the sensor module (110) being connected electrically to the electric connector (170) by way of at least one conductive adhesive (172).

8. Apparatus (146) according to the preceding claim, the conductive adhesive (172) being set up to form a direct electric contact with the electric connector (170) .

9. Method for producing the apparatus (146) according to one of the preceding claims, comprising the following steps:
a) provision of a first housing part (150) of the housing (148);
b) introduction of the sensor module (110) into the first housing part (150); and
c) application of a second housing part (152) of the housing (148).

10. Method according to the preceding method claim, step b) comprising a positively locking connection of the sensor module (110) to the first housing part (150).

11. Method according to either of the two preceding method claims, step b) comprising an introduction of at least one sealing material (158) between the first housing part (150) and the sensor module (110).

## Revendications

1. Dispositif (146) permettant de détecter une pression d'un milieu fluide, dans lequel le dispositif (146) comprend:
- au moins un boîtier (148) avec au moins deux arrivées de pression (168, 169);
- au moins un module de capteur (110), dans lequel le module de capteur (110) est logé dans le boîtier (148), dans lequel le module de capteur (110) comprend:
• au moins un élément de support (112), dans lequel l'élément de support (112) présente au moins un substrat (114) et au moins une masse moulée (116), dans lequel l'élément de support (112) comporte en outre au moins une ouverture de passage (120), dans lequel l'ouverture de passage (120) traverse entièrement l'élément de support (112);
• au moins un élément de capteur de pression (128) pour détecter la pression, dans lequel l'élément de capteur de pression (128) comprend au moins une membrane, dans lequel l'élément de capteur de pression (128) recouvre l'ouverture de passage (120);
**caractérisé en ce que** le module de capteur (110) présente en outre au moins une unité de commande et d'évaluation (134),
dans lequel l'unité de commande et d'évaluation (134) présente au moins un circuit intégré spécifique à l'application et est au moins en partie entourée par la masse moulée (116),
dans lequel le boîtier (148) comprend au moins une première partie de boîtier (150) et au moins une seconde partie de boîtier (152), dans lequel la première partie de boîtier (150) et la seconde partie de boîtier (152) sont matériellement assemblées l'une à l'autre,
dans lequel l'élément de capteur de pression (128) présente un côté supérieur (174) et un côté inférieur (176), dans lequel la membrane (130) se trouve sur le côté supérieur (174), dans lequel le côté inférieur (176) est tourné vers le substrat (114), dans lequel le module de capteur (110) est logé dans le boîtier (148) de telle manière que le côté supérieur (174) soit tourné vers la première partie de boîtier (150),
dans lequel un premier canal de pression (178) et un second canal de pression (180) sont formés dans la première partie de boîtier (150), dans lequel le premier canal de pression (178) est relié à une première arrivée de pression (168) et le second canal de pression (180) est relié à une seconde arrivée de pression (169), dans lequel le premier canal de pression (178) est réalisé de telle manière que l'élément de capteur de pression (128) puisse être soumis à une première pression (p1) par le côté inférieur (176),
dans lequel le second canal de pression (180) est réalisé de telle manière que l'élément de capteur de pression (128) puisse être soumis à une seconde pression (p2) par le côté supérieur (174),
et **en ce que** le premier canal de pression (178) est réalisé essentiellement en forme de U avec une partie de fond (182) et deux parties de branches (184), dans lequel le second canal de pression (180) s'étend à travers entre les deux parties de branches (184).

2. Dispositif (146) selon l'une quelconque des revendications précédentes, dans lequel la masse moulée (116) est configurée de telle manière que la membrane (130) de l'élément de capteur de pression (128) soit au moins en partie non recouverte par la masse moulée (116).

3. Dispositif (146) selon l'une quelconque des revendications précédentes, dans lequel l'élément de capteur de pression (128) est recouvert entièrement ou partiellement avec un premier matériau de protection (132), dans lequel le premier matériau de protection (132) est conçu pour assurer une protection de l'élément de capteur de pression (128) contre des influences extérieures.

4. Dispositif (146) selon l'une quelconque des revendications précédentes, dans lequel le dispositif (146) comprend en outre au moins un matériau d'étanchéité (158), dans lequel le matériau d'étanchéité (158) est conçu pour assembler l'une à l'autre la première partie de boîtier (150) et la seconde partie de boîtier (152) et pour assembler le module de capteur (110) au boîtier (148).

5. Dispositif (146) selon l'une quelconque des revendications précédentes, dans lequel le boîtier (148) comprend au moins un logement (160) destiné à recevoir le module de capteur (110), dans lequel le module de capteur (110) est fixé dans le logement (160) au moyen du matériau d'étanchéité (158).

6. Dispositif (146) selon l'une quelconque des revendications précédentes, dans lequel le boîtier (148) renferme au moins une chambre de pression (164) et au moins une chambre de circuit (166), dans lequel la chambre de pression (164) est étanche par rapport à la chambre de circuit (166), et dans lequel au moins un composant électrique est logé dans la chambre de circuit (166), dans lequel le module de capteur (110) est disposé en partie dans la chambre de pression (164) et en partie dans la chambre de circuit (166) et est étanche par rapport au boîtier (148).

7. Dispositif (146) selon l'une quelconque des revendications précédentes, dans lequel le dispositif (146) comprend en outre au moins un raccord électrique (170), dans lequel le module de capteur (110) est relié électriquement au raccord électrique (170) par au moins un adhésif conducteur (172).

8. Dispositif (146) selon la revendication précédente, dans lequel l'adhésif conducteur (172) est conçu pour former un contact électrique direct avec le raccord électrique (170).

9. Procédé de fabrication du dispositif (146) selon l'une quelconque des revendications précédentes, comprenant les étapes suivantes:
a) préparer une première partie de boîtier (150) du boîtier (148);
b) introduire le module de capteur (110) dans la première partie de boîtier (150); et
c) poser une seconde partie de boîtier (152) du boîtier (148) .

10. Procédé selon la revendication de procédé précédente, dans lequel l'étape b) comprend un assemblage par emboîtement du module de capteur (110) avec la première partie de boîtier (150).

11. Procédé selon une des deux revendications de procédé précédentes, dans lequel l'étape b) comprend une introduction d'au moins un matériau d'étanchéité (158) entre la première partie de boîtier (150) et le module de capteur (110).
